## Europäisches Patentamt
## European Patent Office
## Office européen des brevets

(19) ⊚

(11) Numéro de publication: **0 192 563 B1**

(12) **FASCICULE DE BREVET EUROPEEN**

(45) Date de publication du fascicule du brevet:
**11.01.89**

(51) Int. Cl.⁴: **F16C 39/06**

(21) Numéro de dépôt: **86400299.3**

(22) Date de dépôt: **12.02.86**

(54) Dispositif de mesure de l'induction dans l'entrefer d'un palier magnétique.

(30) Priorité: **15.02.85 FR 8502257**

(43) Date de publication de la demande:
**27.08.86 Bulletin 86/35**

(45) Mention de la délivrance du brevet:
**11.01.89 Bulletin 89/2**

(84) Etats contractants désignés:
**CH DE GB IT LI SE**

(56) Documents cités:
**DE-A- 2 420 166**
**US-A- 3 466 477**
**US-A- 3 855 529**
**US-A- 3 932 811**

(73) Titulaire: **SOCIETE EUROPEENNE DE PROPULSION (S.E.P.) Société Anonyme dite:, 24 Rue Salomon de Rothschild, F-92150 Suresnes(FR)**

(72) Inventeur: **Habermann, Helmut, 63 rue de Bizy, F-27200 Vernon(FR)**

(74) Mandataire: **Thevenet, Jean-Bruno et al, Cabinet BEAU DE LOMENIE 55 rue d'Amsterdam, F-75008 Paris(FR)**

## Description

La présente invention concerne un dispositif apte à mesurer la force portante d'un palier magnétique comprenant une armature de rotor en matériau ferromagnétique, un stator constitué d'une part d'une carcasse en matériau ferromagnétique définissant une succession de pôles et d'encoches dans sa partie située en regard de l'armature de rotor et d'autre part de bobines d'électro-aimants disposées dans les encoches de ladite carcasse, des moyens de mesure de l'induction dans l'entrefer du palier et un entrefer situé entre le rotor et le stator et comprenant.

Dans un palier magnétique actif, le courant d'excitation des électro-aimants de stator est asservi à partier des signaux de détection délivrés par des détecteurs qui mesurent à chaque instant les déplacements du rotor de palier par rapport au stator, afin de maintenir le rotor dans une position prédéterminée.

La force portante d'un palier magnétique est proprtionnelle au carré de l'induction magnétique dans l'entrefer du palier et à la surface active utile du circuit magnétique du palier.

Il est souvent utile d'effectuer une mesure précise de la force d'un palier. C'est par exemple le cas lorsque l'on souhaite mesurer la force de traction d'une tôle reposant sur des paliers magnétiques.

Dans ce cas, la détermination de l'induction magnétique nécessaire à la détermination de la force portante est effectuée par un calcul qui prend en compte le résultat de différentes mesures notamment de l'entrefer et du courant d'excitation des électro-aimants du palier. Cette méthode ne peut cependant pas tenir compte du champ rémanent des électro-aimants. L'erreur ainsi introduite reste relativement faible, mais devient non négligeable pour certaines applications.

On connaît par le document US-A 3 855 529 un dispositif pour la mesure de flux dans l'entrefer situé entre le rotor et le stator d'une machine électrique à champ tournant, lequel dispositif met en œuvre une bobine d'induction placée dans une encoche formée dans la face du stator située en regard du rotor qui présente lui-même des pièces polaires séparées par des encoches. Dans ce cas, la bobine d'induction s'étend dans le sens circonférentiel sur une distance correspondant au pas des encoches du rotor. Un tel dispositif localisé ne peut cependant être utilisé pour déterminer à un instant donné la valeur de l'induction dans l'ensemble de l'entrefer d'un palier magnétique.

La présente invention vise précisément à remédier aux inconvénients précités et à réaliser une mesure directe de l'induction dans l'ensemble de l'entrefer d'un palier magnétique sans affecter l'efficacité du palier magnétique et de manière à permettre une détermination précise de la force d'attraction du palier.

L'invention a encore pour but de permettre une mesure d'induction magnétique sans qu'il soit nécessaire de disposer des éléments de mesure sur le rotor et donc d'utiliser des collecteurs pour prélever des signaux qui seraient délivrés par ces éléments de mesure.

Ces buts sont atteints conformément à l'invention, en ce que le dispositif comprend des moyens de détermination de la force portante à partir de la valeur de l'induction mesurée et de la valeur de la surface active utile du circuit magnétique du palier et en ce que les moyens de mesure de l'induction comprennent un ensemble de petites encoches de faible largeur réalisées dans le sens longitudinal du rotor et réparties à la périphérie de celui-ci, un ensemble de petites bobines disposées dans les faces d'extrémité des pôles de la carcasse de stator situées en regard du rotor, parallèlement auxdites petites encoches, et des moyens de détection de la tension alternative induite dans chaque petite bobine du fait du passage des petites encoches du rotor en face desdites petites bobines, et en ce que la largeur des petites bobines disposées dans les pôles de la carcasse de stator est sensiblement égale à la largeur des petites encoches réalisées à la périphérie du rotor et inférieure à la largeur d'un pôle de la carcasse de stator.

Selon une caractéristique particulière, les petites bobines disposées dans les pôles de la carcasse de stator et les petites encoches réalisées à la périphérie du rotor sont inclinées par rapport à l'axe de rotation du rotor.

Selon une autre caractéristique particulière, qui permet d'éviter une modulation de l'induction mesurée, la distance entre deux petites encoches adjacentes correspond à la largeur d'un pôle de la carcasse de stator.

La largeur des petites bobines disposées dans les pôles de la carcasse de stator est sensiblement égale à la largeur des petites encoches réalisées à la périphérie du rotor.

Avantageusement, pour ne pas affecter la capacité de charge du palier tout en conservant une bonne sensibilité de mesure, la largeur des petites bobines et des petites encoches correspond environ au dixième de la largeur d'un pôle de la carcasse de stator.

Selon un mode particulier de réalisation, les petites bobines sont rapportées par collage sur les faces d'extrémité des pôles de la carcasse de stator.

Selon un autre mode de réalisation, les petites bobines sont disposées dans de petites encoches réalisées dans les faces d'extrémité des pôles de la carcasse de stator.

D'autres caractéristiques et avantages de l'invention ressortiront de la description suivante, faite en référence au dessin annexé, sur lequel:

– la figure 1 est une vue schématique partielle en coupe perpendiculaire à l'axe d'un palier magnétique actif radial incorporant le dispositif de mesure d'induction selon l'invention,

– la figure 2 est une vue développée de dessus de la surface extérieure du rotor du palier de la figure 1,

– la figure 3 est une vue de pôles du stator du palier de la figure 1, selon la ligne III–III de la figure 1,

– la figure 4 est une vue de détail d'un pôle de stator en coupe selon la ligne IV–IV de la figure 3, et,
– la figure 5 est une variante de réalisation du pôle de stator de la figure 4.

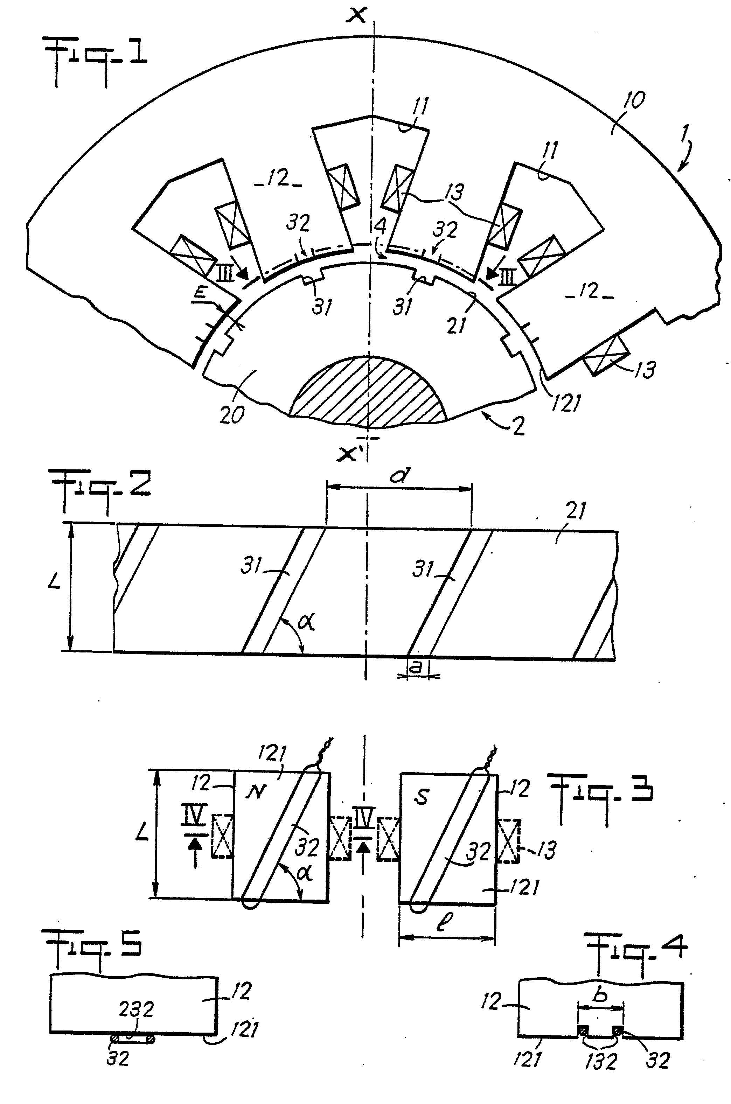

La figure 1 représente une partie d'un palier magnétique actif radial comprenant un stator 1 constitué par une culasse 10 définissant des encoches 11 et des pièces polaires 12, et des enroulements d'électro-aimant 13 disposés autour des pièces polaires 12 dans les encoches 11. La culasse 10 est réalisée par un empilement de tôles ferromagnétiques perpendiculairement à l'axe du palier, c'est-à-dire parallèlement au plan de la figure 1. Le stator 1 est coaxial à un rotor 2 constitué par une armature 20 en matériau ferromagnétique feuilleté, qui délimite avec les pôles 12 un entrefer de largeur E.

La structure de base d'un palier magnétique actif est bien connue et ne sera pas décrite de façon détaillée. On notera cependant que le rotor 2 peut être disposé soit à l'intérieur du stator 1, comme représenté sur la figure 1, la surface cylindrique externe 21 du rotor 2 faisant face aux surfaces terminales 121 des pièces polaires 12 du stator 1, soit à l'extérieur du stator 1. Dans ce dernier cas, les pièces polaires 12 du stator 1 sont tournées vers l'extérieur et c'est la surface cylindrique interne du rotor annulaire qui est située en regard des surfaces terminales des pièces polaires 12 du stator 1.

La capacité de charge d'un palier magnétique est proportionnelle au carré de l'induction magnétique dans l'entrefer et à la surface active utile. La surface active utile est constituée par la somme des surfaces des faces terminales des pôles 12 du circuit magnétique de stator et est donc proportionnelle au diamètre D du rotor à l'entrefer et à la largeur L du palier magnétique. La surface active utile étant constante pour un palier magnétique donné, la force d'attraction du palier, qui est la résultante des forces d'attraction des différents électro-aimants constitués par des paires de pôles 12 adjacents de polarités opposées et les bobinages correspondants, est donc proportionnelle à l'induction magnétique dans l'entrefer du palier.

Dans un palier magnétique, le circuit de flux des électro-aimants est tel que la plus grande partie de l'énergie de magnétisation se trouve dans l'entrefer. Si par ailleurs les perméabilités relatives des tôles magnétiques du rotor et du stator sont élevées, on peut considérer que, pour un entrefer donné, l'induction magnétique est proportionnelle à l'intensité I du courant circulant dans les enroulements 13 des électro-aimants de stator. Dans ce cas, le mesure de l'intensité I du courant d'excitation des électro-aimants de stator, combinée à une mesure précise de la valeur de l'entrefer, permet de déterminer la force d'attraction du palier. Une telle mesure de force repose ainsi sur une détermination indirecte de la valeur de l'induction magnétique dans l'entrefer. Malgré sa commodité, cette méthode n'est pas entièrement satisfaisante pour certaines applications, ou nécessite l'introduction de facteurs de correction, et ne tient pas compte du champ rémanent des électro-aimants.

Le palier magnétique selon l'invention est ainsi équipé d'un dispositif de mesure directe de l'induction magnétique dans l'entrefer du palier, et par suite permet de déterminer de façon particulièrement fiable la force portante du palier.

Ce dispositif de mesure d'induction comprend essentiellement un ensemble de petites bobines 32 placées sur le stator 1 et coopérant avec de petites encoches 31 réalisées sur la surface cylindrique 21 de l'armature 20 du rotor qui délimite l'entrefer 4 du palier. Chaque face terminale 121 d'une pièce polaire 12 du stator 1 comporte une petite bobine 32 et le nombre des petites encoches 31 réalisées sur le rotor 2 est égal au nombre total de petites bobines 32, et donc des pôles du stator 1.

Les petites bobines 32 et les petites encoches 31 sont disposées dans le sens longitudinal du palier (figures 2 et 3), mais sont cependant inclinées d'un même angle X par rapport à l'axe de rotation X'X du palier, d'une façon analogue aux encoches réalisées dans le rotor d'un moteur inductif qui sont inclinées par rapport à l'axe de rotation de ce rotor.

La distance d qui sépare deux encoches successives 31 du rotor est égale à la largeur $\underline{1}$ d'un pôle 12 du stator 1. On évite ainsi tout phénomène de modulation du signal délivré par les petites bobines 32.

En fonctionnement, à chaque passage d'une petite encoche 31 sous une petite bobine 32, une tension alternative est induite dans cette petite bobine 32. Compte tenu du fait que les caractéristiques géométriques de chaque petite bobine 32 sont bien déterminées, la tension alternative produite au passage d'une encoche 31 sous la bobine 32 est proportionnelle à l'induction magnétique dans l'entrefer 4.

En prélevant les signaux disponibles aux bornes des différentes petites bobines 32 disposées sur les différents pôles 12 du stator 1 lorsque la rotation du rotor 2 fait passer des encoches 31 en regard desdites petites bobines 32, on peut ainsi obtenir une valeur proportionnelle à l'induction magnétique B et en déduire la valeur de la force du palier.

La largeur $\underline{a}$ d'une encoche 31 correspond à la largeur b d'une bobine 32. Avantageusement, on choisit des largeurs a, b d'encoche et de bobine qui correspondent environ au dixième de la largeur $\underline{1}$ d'un pôle 12. Ceci permet de ne pas réduire sensiblement la capacité de charge du palier tout en conduisant à des tensions induites aux bornes des petites bobines 32 qui sont suffisamment importantes pour assurer une mesure d'induction fiable et sensible.

Chaque petite bobine 32 peut être insérée dans de petites encoches 132 réalisées dans la face terminale 121 des pièces polaires 12 du stator (figure 4). Toutefois, selon une variante, les petites bobines 32, dont l'épaisseur est bien inférieur à la largeur E de l'entrefer moyen 4, sont simplement rapportées sur les faces terminales 121 des pièces polaires 12 et sont fixées sur ces faces 121 par exemple par l'intermédiaire d'une petite couche de colle 232. La fixation des petites bobines de mesure 32 est facilitée par le fait que le diamètre d'un palier magnétique au niveau de l'entrefer 4 est en général relativement important.

On notera que le dispositif décrit ci-avant n'exige aucun contact tournant dans la mesure où toutes les bobines sont placées sur le stator 1, qu'il s'agisse des enroulements 13 d'électro-aimants du palier ou des petites bobines 32 de prélèvement de signal. Par suite, la réalisation pratique est particulièrement simple et la fiabilité est importante.

Un palier magnétique équipé du dispositif de mesure d'induction selon l'invention peut être utilisé par exemple dans le cadre de l'application décrite dans la demande de brevet français 83 18435 déposée le 18 novembre 1983 et intitulée : «Dispositif de mesure de la tension logitudinale d'une bande de matériau.» Dans cette application, qui peut concerner par exemple la mesure des forces de traction dans un laminoir, la mesure de l'induction dans l'entrefer d'un palier conformément à la présente invention peut être substituée à la mesure du courant dans les enroulements du palier magnétique actif servant de détecteur d'effort pour délivrer un signal fonction de l'effet de traction exercé sur la bande de matériau en appui sur un rouleau monté sur ledit palier magnétique actif.

**Revendications**

1. Dispositif apte à mesurer la force portante d'un palier magnétique comprenant une armature (20) de rotor (2) en matériau ferromagnétique, un stator (1) constitué d'une part d'une carcasse (10) en matériau ferromagnétique définissant une succession de pôles (12) et d'encoches (11) dans sa partie située en regard de l'armature (20) de rotor (2) et d'autre part de bobines d'électro-aimants (13) disposées dans les encoches (11) de ladite carcasse (10), et un entrefer (E) situé entre le rotor (2) et le stator (1), comprenant des moyens de mesure de l'induction dans l'intrefer du palier et caractérisé en ce qu'il comprend des moyens de détermination de la force portante à partir de la valeur de l'induction mesurée et de la valeur de la surface active utile du circuit magnétique du palier et en ce que les moyens de mesure de l'induction comprennent un ensemble de petites encoches (31) de faible largeur réalisées dans le sens longitudinal du rotor (2) et réparties à la périphérie (21) de celui-ci, un ensemble de petites bobines (32) disposées dans les faces d'extrémité (121) des pôles (12) de la carcasse (10) de stator situées en regard du rotor, parallèlement auxdites petites encoches (31), et des moyens de détection de la tension alternative induite dans chaque petite bobine (32) du fait du passage des petites encoches (31) du rotor en face desdites petites bobines (32), et en ce que la largeur (b) des petites bobines (32) disposées dans les pôles (12) de la carcasse (10) de stator est sensiblement égale à la largeur (a) des petites encoches (31) réalisées à la périphérie (21) du rotor (2) et inférieure à la largeur (l) d'un pôle (12) de la carcasse (10) de stator.

2. Dispositif selon la revendication 1, caractérisé en ce que les petites bobines (32) disposées dans les pôles (12) de la carcasse (10) de stator et les petites encoches (31) réalisées à la périphérie (21) du rotor (2) sont inclinées par rapport à l'axe de rotation du rotor (2).

3. Dispositif selon la revendication 1 ou la revendication 2, caractérisé en ce que la distance (d) entre deux petites encoches adjacentes (31) correspond à la largeur (l) d'un pôle (12) de la carcasse (10) de stator.

4. Dispositif selon l'une quelconque des revendications 1 à 3, caractérisé en ce que la largeur (a, b) des petites bobines (32) et des petites encoches (31) correspond environ au dixième de la largeur (l) d'un pôle (12) de la carcasse (10) de stator.

5. Dispositif selon l'une quelconque des revendications 1 à 4, caractérisé en ce que les petites bobines (32) sont rapportées par collage sur les faces d'extrémité (121) des pôles (12) de la carcasse (10) de stator.

6. Dispositif selon l'une quelconque des revendications 1 à 4, caractérisé en ce que les petites bobines (32) sont disposées dans de petites encoches (132) réalisées dans les faces d'extrémité (121) réalisées dans les faces d'extrémité (121) des pôles (12) de la carcasse (10) de stator.

7. Dispositif selon l'une quelconque des revendications 1 à 6, caractérisé en ce qu'il est appliqué à la mesure de la force de traction dans les laminoirs.

**Claims**

1. Device capable of measuring the portative force of a magnetic bearing comprising a rotor (2) armature (20) made of ferromagnetic material, a stator (1) constituted, on the one hand, by a frame (10) made of ferromagnetic material defining a succession of poles (12) and of notches (11) in its part situated opposite the armature (20) of the rotor (2) and on the other hand, by electro-magnet coils (13) disposed in the notches (11) of said frame (10), and an air gap (E) located between the rotor (2) and the stator (1) comprising means of measuring the air gap of the bearing and characterized in that it comprises means for determining the portative force from the measured induction value and from the value of the serviceable active surface of the bearing magnetic circuit and in that the means for measuring the induction comprises an assembly of small notches (31) of small width made in the longitudinal direction of the rotor (2) and distributed on the periphery (21) thereof, an assembly of small coils (32) disposed in the end faces (121) of the poles (12) of the stator frame (10) situated opposite the rotor, in parallel to said small notches (31), and means for detecting (32) due to the passage of the small notches (31) of the rotor opposite said small coils (32), and in that the width (1) of said small coils (32) arranged in the poles (12) of the stator frame (10) is substantially equal to the width (a) of the small notches (31) produced on the periphery (21) of the rotor (2) and is less than the width (1) of a pole (12) of the stator frame (10).

2. Device according to Claim 1, characterized in that the small coils (32) disposed in the poles (12) of the stator frame (10) and the small notches (31) made on the periphery (21) of the rotor (2) are inclined with respect to the axis of rotation of the rotor (2).

3. Device according to Claim 1 or Claim 2, characterized in that the distance (d) between two adjacent small notches (31) corresponds to the width (1) of a pole (12) of the stator frame (10).

4. Device according to any one of Claims 1 to 3, characterized in that the width (a, b) of the small coils (32) and of the small notches (31) substantially corresponds to about one tenth of the width (1) of a pole (12) of the stator frame (10).

5. Device according to any one of Claims 1 to 4, characterized in that the small coils (32) are adhesively fixed on the end faces (121) of the poles (12) of the stator frame (10).

6. Device according to any one of Claims 1 to 4, characterized in that the small coils (32) are disposed in small notches (132) produced in the end faces (121) of the poles (12) of the stator frame (10).

7. Device according to any one of Claims 1 to 6, characterized in that it is applied to the measurement of the force of traction in rolling mills.

**Patentansprüche**

1. Vorrichtung, welche geeignet ist, die Tragkraft eines Magnetlagers zu messen, mit einer Armierung bzw. einem Anker (20) eines Rotors (2) aus ferromagnetischem Material, einem Stator (1), der einerseits aus einem Polgehäuse (10) aus ferromagnetischem Material gebildet ist, das eine Aufeinanderfolge von Polen (12) und Nuten (11) in seinem dem Anker (20) des Rotors (2) gegenüberliegenden Bereich bildet, und andererseits aus Spulen von Elektromagneten (13) gebildet ist, die in den Nuten (11) des Polgehäuses (10) angeordnet sind, und mit einem Luftspalt (E), der sich zwischen dem Rotor (2) und dem Stator (1) befindet, wobei Einrichtungen zur Messung der Induktion in den Luftspalt des Lagers vorgesehen sind, dadurch gekennzeichnet, daß sie Einrichtungen zur Bestimmung der Tragkraft ausgehend von dem gemessenen Induktionswert und dem Wert der aktiven Oberfläche aufweist, die in dem magnetischen Kreis des Lagers verwendbar ist, und daß die Einrichtungen zur Messung der Induktion eine Anordnung von kleinen Nuten (31) von geringer Breite, die in Längsrichtung des Rotors (2) ausgebildet und an seinem Umfang (21) verteilt angeordnet sind, eine Anordnung von kleinen Spulen (32), die in den Endseiten (121) der Pole (12) des Polgehäuses (10) des Stators dem Rotor gegenüberliegend, parallel zu den kleinen Nuten (31) angeordnet sind, und Einrichtungen zum Erfassen der in jede kleine Spule (32) induzierten Wechselspannung aufgrund des Vorbeistreichens der kleinen Nuten (31) des Rotors an den kleinen Spulen (32) aufweisen, und daß die Breite (b) der in den Polen (12) des Polgehäuses (10) des Stators angeordneten kleinen Spulen (32) im wesentlichen gleich der Breite (a) der kleinen Nuten (31), die an dem Umfang (21) des Rotors (2) ausgebildet sind, und geringer ist als die Breite (1) eines Poles (12) des Polgehäuses (10) des Stators.

2. Vorrichtung nach Anspruch 1, dadurch gekennzeichnet, daß die in den Polen (12) des Polgehäuses (10) des Stators angeordneten kleinen Spulen (32) und die an dem Umfang (21) des Rotors (2) ausgebildeten kleinen Nuten (31) gegenüber der Drehachse des Rotors (2) geneigt sind.

3. Vorrichtung nach Anspruch 1 oder nach Anspruch 2, dadurch gekennzeichnet, daß der Abstand (d) zwischen zwei benachbarten kleinen Nuten (31) der Breite (1) eines Poles (12) des Polgehäuses (10) des Stators entspricht.

4. Vorrichtung nach einem der Ansprüche 1 bis 3, dadurch gekennzeichnet, daß die Breite (a, b) der kleinen Spulen (32) und der kleinen Nuten (31) ungefähr einem Zehntel der Breite (1) eines Poles (12) des Polgehäuses (10) des Stators entspricht.

5. Vorrichtung nach einem der Ansprüche 1 bis 4, dadurch gekennzeichnet, daß die kleinen Spulen durch Kleben auf die Endseiten (121) der Pole (12) des Polgehäuses (10) des Stators aufgesetzt sind.

6. Vorrichtung nach einem der Ansprüche 1 bis 4, dadurch gekennzeichnet, daß die kleinen Spulen (32) in kleinen Nuten (132) angeordnet sind, die in den Endseiten (121) der Pole (12) des Polgehäuses (10) des Stators ausgebildet sind.

7. Vorrichtung nach einem der Ansprüche 1 bis 6, dadurch gekennzeichnet, daß sie bei der Messung der Zugkraft in Walzwerken verwendbar ist.

Fig-1

Fig-2

Fig-3

Fig-5

Fig-4